# EUROPÄISCHE PATENTANMELDUNG

(11) **EP 1 122 738 A1**
(43) Veröffentlichungstag der Anmeldung: **08.08.2001**
(21) Anmeldenummer: 01101063.4
(22) Anmeldetag: 18.01.2001
(51) Int. Cl.: G11C 7/00, G11C 11/407, G11C 11/409

(54) **Schaltungsanordnung zur Generierung eines Ausgangs-Taktsignals mit optimierter Signalgenerierungszeit**

(30) Priorität: 31.01.2000 DE 10004108
(71) Anmelder: Infineon Technologies AG, 81669 München (DE)
(72) Erfinder: Hein, Thomas, 81541 München (DE); Marx, Thilo, 80997 München (DE); Heyne, Patrick, 81243 München (DE); Partsch, Torsten, Resear Triangle Park, NC 27709 (US)
(74) Vertreter: MÜLLER & HOFFMANN Patentanwälte

(57) **Zusammenfassung**

Bei DDR-SDRAM-Speicherchips wird ein hochpräzises Ausgangs-Taktsignal benötigt, um die gespeicherten Daten im richtigen Moment auf die Datenbahn zu geben. Dieses wird durch eine symmetrische Schaltungsanordnung (1) generiert, die durch Integration eines Multiplexers in einen TaktverhältnisAusgleicher das Ausgangs-Taktsignal außerdem in minimaler Zeit erzeugt.

## Beschreibung

Die Erfindung betrifft eine Schaltungsanordnung zur Generierung eines lokalen Ausgangs-Taktsignales für die Steuerung des Zeitpunktes der Ausgabe von Daten aus einer Ausgabeverzögerungsvorrichtung am Ausgang eines Zellenfeldes eines Speichers auf eine Datenbahn, bei der
- das lokale Ausgangs-Taktsignal unter Verwendung eines Taktverhältnis-Ausgleichers und eines Multiplexers in Abhängigkeit eines differentiellen Eingangs-Taktsignales und eines programmierbaren Umschaltsignales derart generierbar ist,
- dass die Ausgabe der Daten auf die Datenbahn synchronisiert ist mit entweder ganzen Taktzyklen der Datenbahn oder auch ganzzahligen Bruchteilen hiervon.

Speicherchips bestehen in der Regel aus mehreren Zellenfeldern bzw. Zellfelldstreifen, in welchen die Daten gespeichert werden, wobei die Zellenfelder durch mehrere Steuereinrichtungen sowie Datenbahnen mit Ein-/Ausgängen des Speicherchips in Verbindung stehen.

Um den beim Datenzugriff auf die Zellenfelder entstehenden Datenstrom zu koordinieren, wird ein Taktsignal verwendet. Dieses Signal treibt, nachdem es auf einen Signal-Eingang eines Zellenfeldes gegeben wurde, über das gesamte Zellenfeld und sorgt dafür, dass die in den aktivierten Speicherzellen befindlichen Daten gelesen und an den Ausgang des Zellenfeldes gebracht werden, von wo aus sie auf die Datenbahn gelangen.

Bei "Double-Data-Rate-Synchronous-Dynamic-Random-Access-Memory"-Speicherchips (Doppeldatenrate-Speicherchips mit synchronem Zugriff), kurz DDR-SDRAMs, wird als Taktsignal ein differentielles Eingangs-Taktsignal verwendet. Dieses besteht aus zwei Takten gleicher Frequenz, die um einen halben Taktzyklus gegeneinander verschoben sind.

Um Datenkollisionen zu vermeiden, müssen die Daten, die an den Ausgang des Zellenfeldes gebracht wurden, zu einem genau definierten Ausgabe-Zeitpunkt, der mit dem Takt der Datenbahn synchronisiert sein muß, auf die Datenbahn ausgegeben werden. Die Ausgabe der Daten auf die Datenbahn kann dabei synchronisiert sein mit entweder ganzen Taktzyklen der Datenbahn oder auch ganzzahligen Bruchteilen hiervon. Da die einzelnen Daten, auf die zugegriffen werden soll, an verschiedenen Orten innerhalb des Zellenfeldes gespeichert sind, ist es möglich, dass die einzelnen Daten in "verkehrter" Reihenfolge, zu früh oder zu spät am Ausgang des Zellenfeldes eintreffen. Deshalb ist es insbesondere bei DDR-SDRAMs üblich, am Ausgang eines Zellenfeldes eine Ausgabe-Verzögerungsvorrichtung vorzusehen, die dafür sorgt, dass die eintreffenden Daten richtig sortiert und zu einem genau definierten Zeitpunkt auf die Datenbahn ausgegeben werden. Diese Ausgabe-Verzögerungsvorrichtung ist beispielsweise durch ein an sich bekanntes Schieberegister realisiert.

Zur Steuerung der Datenausgabe durch die Ausgabeverzögerungsvorrichtung wird unter anderem ein hochpräzises Ausgabe-Taktsignal benötigt, welches durch die beiden Takte des differentiellen Eingangs-Taktsignales lokal bei der Ausgabeverzögerungsvorrichtung neu erzeugt wird. Dieses Ausgabe-Taktsignal muss ein Taktverhältnis von nahezu 50 % aufweisen. Das differentielle Eingangs-Taktsignal selbst ist für diese Aufgabe ungeeignet, da die fallenden Flanken des differentiellen Taktes durch das Treiben über das Zellenfeld "verschmieren", also an Schärfe und damit an Taktkraft verlieren.

Die Generierung des Ausgangs-Taktsignales wird normalerweise dadurch erreicht, dass nur eine Flankenart des differentiellen Eingangs-Taktsignales, zum Beispiel die steigenden Flanken, welche nicht dem Problem der "Verschmierung" unterliegen und damit ein brauchbares Maß für sowohl ganze als auch beispielsweise halbe Taktzyklen liefern, einen Taktverhältnis-Ausgleicher beaufschlagen. Dieser erzeugt aus den beiden steigenden Flanken der beiden Taktsignale des differentiellen Eingangs-Taktsignales das aus zwei Taktsignalen bestehende Ausgangs-Taktsignal, welches aufgrund sowohl scharfer steigender Flanken als auch scharfer fallender Flanken ein "maximales" Taktverhältnis aufweist, d. h. die Pulse der beiden Taktsignale sind maximal breit, aber überlappen sich nicht gegenseitig.

Damit die obig beschriebene Ausgabe-Verzögerungsvorrichtung möglichst flexibel einsetzbar ist, ist das die Ausgabe-Verzögerungsvorrichtung steuernde, durch den Taktverhälnis-Ausgleicher erzeugte Ausgabe-Taktsignal über ein programmierbares Umschaltsignal über den Zeitraum beliebiger Taktzyklen zusätzlich veränderbar. Das Umschaltsignal beeinflusst damit die Taktrate des Ausgangs-Taktsignales und bestimmt darüber, zu welchen der möglichen Ausgabezeitpunkte die entsprechenden Daten (Bits) ausgegeben werden. Die möglichen Ausgabezeitpunkte selbst werden, wie oben beschrieben, durch das differentielle Eingangs-Taktsignal bestimmt.

Das Verändern des durch den Taktverhälnis-Ausgleicher "bereinigten" Ausgangs-Taktsignals wird beispielsweise durch einen nachgeschaltenen Multiplexer erreicht, der in Abhängigkeit des programmierbaren Umschalt-Signales die Signalpegel der beiden Taktsignale des Ausgangs-Taktsignales beliebig vertauscht.

Nachteilig am obig beschriebenen Stand der Technik ist, dass trotz Taktverhältnis-Ausgleicher aufgrund von Signallaufzeitunterschieden innerhalb des Taktverhältnis-Ausgleiches die beiden "bereinigten" Taktsignale am Ausgang des Taktverhältnis-Ausgleichers nicht absolut genau zueinander invertiert, sondern zusätzlich um ein kleines Stück gegeneinander verschoben sind, was einen Signalüberlapp ergibt und damit zu Problemen bei der Datenausgabe führen kann. Desweiteren bewirkt die Hintereinanderschaltung von Taktverhältnis-Ausgleicher und Multiplexer, dass bis zum "Fertigstellen" des Ausgangs-Taktsignales relativ viel Zeit vergeht, was zu Synchronisationsproblemen mit dem Takt der Datenbahn führen kann und damit die maximale Taktfrequenz des Speichers begrenzt.

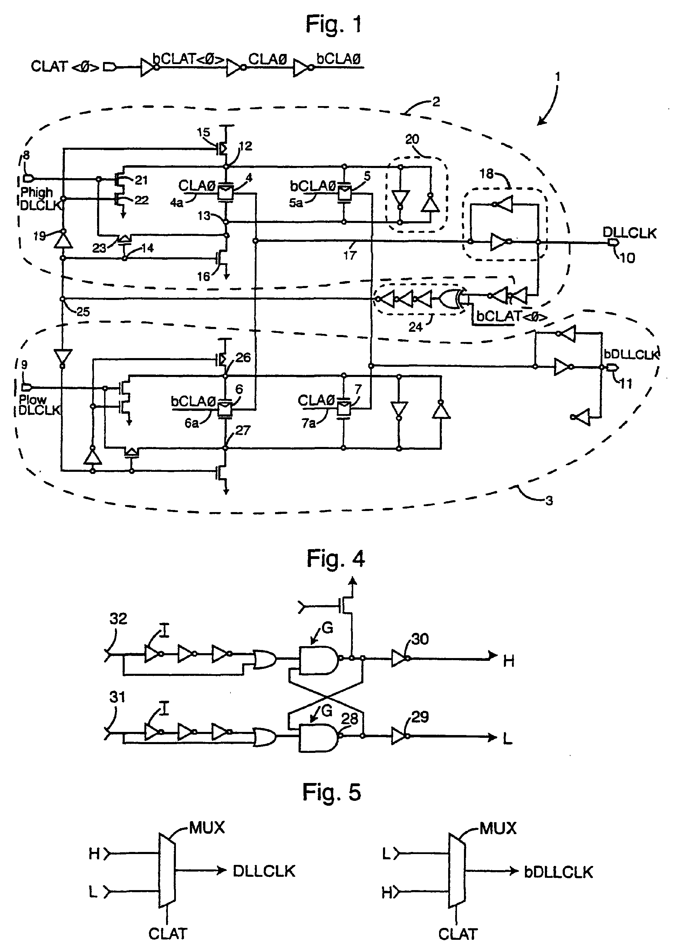

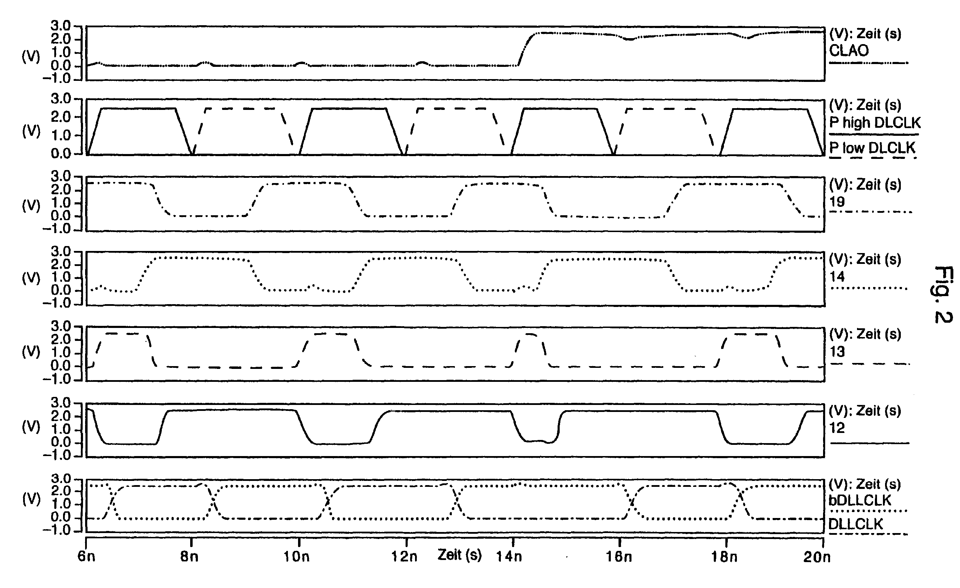

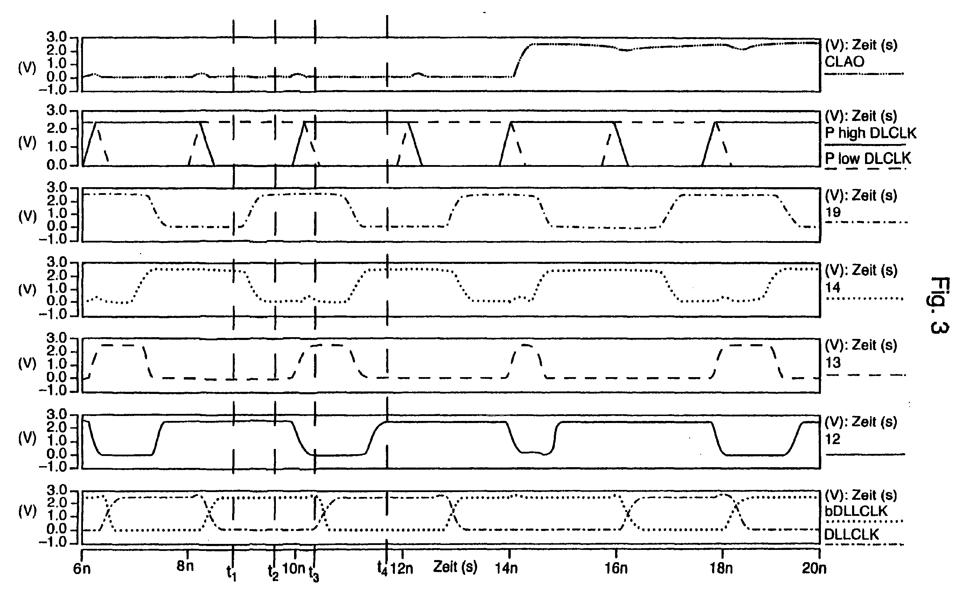

In Fig. 4 ist ein Taktverhältnis-Ausgleicher gemäß dem Stand der Technik dargestellt:
Trifft eine steigende Flanke auf beispielsweise einen Eingang 31 einer Schaltung aus Invertern I und Gattern G, so wird durch den dadurch entstehenden Impuls sowohl ein Knoten 29 als auch ein Knoten 30 entweder auf hohe ("H") oder niedrige ("L") Spannung gesetzt. Jedoch benötigt das Signal vom Ausgang 28 eines UND-Gatters bis zum Knoten 30 mehr Laufzeit als vom Knoten 28 bis zum Knoten 29. Die Knoten 29 und 30 werden also zu unterschiedlichen Zeitpunkten gesetzt, d. h. es entsteht ein Signalüberlapp.

Die Knoten 29, 30 sind in üblicher Weise mit einem Multiplexer MUX verbunden (vgl. Fig. 5), der in Abhängigkeit von einem Umschaltsignal CLAT und dem jeweiligen Zustand der Knoten 29, 30 ("H" oder "L") ein Ausgangs-Taktsignal DLLCLK bzw. bDLLCLK liefert.

Der Erfindung liegt damit die Aufgabe zugrunde, eine Schaltungsanordnung anzugeben, die die obig beschriebenen laufzeitbedingten Nachteile beseitigt.

Die Aufgabe wird erfindungsgemäß dadurch gelöst, dass
- der Taktverhältnis-Ausgleicher aus zwei gekoppelten, gegeneinander symmetrischen Zweigen aufgebaut ist, in welche
- der Multiplexer mit jeweils wenigstens zwei programmierbaren Signal-Einspeisestellen integriert ist, die das Ausgangs-Taktsignal in Abhängigkeit des Umschaltsignales erzeugen und die über Schalter mit den Ausgängen der Schaltungsanordnung verbunden sind,
- wobei die Schalter in Abhängigkeit des differentiellen Eingangs-Taktsignales geöffnet oder geschlossen werden.

Vorteilhafte Weiterbildungen ergeben sich insbesondere aus den Unteransprüchen.

Der Taktverhältnis-Ausgleicher ist aus zwei gegeneinander symmetrischen Zweigen aufgebaut. Jeweils einer der beiden Eingänge der Schaltungsanordnung ist mit einem der beiden Zweige verbunden. Jeder dieser Zweige hat einen Arbeitszyklus, der sich periodisch wiederholt und in zwei Phasen aufgeteilt werden kann: Die Ausgangs-Taktsignal-Vorbereitungsphase und die Ausgangs-Taktsignal-Ausgabephase. Die Arbeitsphasen der beiden Zweige sind zueinander komplementär, d. h., während sich der eine Zweig in der Ausgangs-Taktsignal-Vorbereitungsphase befindet, befindet sich der andere Zweig der Schaltungsanordung in der Ausgangs-Taktsignal-Ausgabephase.

Jeder Zweig weist mindestens zwei Signal-Einspeisestellen auf, die über jeweils einen Schalter, beispielsweise durch Transferglieder realisiert, mit einem der Ausgänge der Schaltungsanordnung verbunden sind. In der Ausgangs-Taktsignal-Vorbereitungsphase wird das nächste auszugebende Ausgangs-Taktsignal an den beiden Signal-Einspeisestellen in Abhängigkeit des Umschaltsignales des jeweiligen Zweiges vorbereitet, wobei die Schalter geöffnet sind, das Ausgangs-Taktsignal also nicht an die Ausgänge der Schaltungsanordnung gelangen kann. In der Ausgangs-Taktsignal-Ausgabephase, die durch eine steigende Flanke des differentiellen Eingangs-Taktsignals am Eingang des jeweiligen Zweiges eingeleitet wird, ist der Schalter geschlossen, das in der vorangegangenen Ausgangs-Taktsignal-Vorbereitungsphase vorbereitete Ausgangs-Taktsignal wird somit an die beiden Ausgänge gelegt. Danach werden die beiden Schalter wieder geschlossen.

Die beiden Zweige sind dabei derart gekoppelt, dass die Ausgabe des Ausgangssignals durch den einen Zweig das Starten der Signal-Vorbereitungsphase des anderen Zweiges bewirkt und umgekehrt.

Ein wesentliches Merkmal der vorliegenden Erfindung ist es also, dass die Funktion des Multiplexers durch den Taktverhältnis-Ausgleicher selbst übernommen wird, indem er mit Signal-Einspeisestellen versehen wird. Es muss also nicht, wie bisher im Stand der Technik geschehen, ein durch einen Taktverhältnis-Ausgleicher erzeugtes Signal in weiteres Mal durch einen Multiplexer manipuliert werden, um 'das gewünschte Ausgangs-Taktsignal zu erhalten, sondern es wird das gewünschte Ausgangs-Taktsignal in einem einzigen Prozeß erzeugt. Dies hat den Vorteil, dass der hinter den Taktverhältnis-Ausgleicher geschaltete Multiplexer entfällt, womit die im Stand der Technik benötigte Verarbeitungszeit des Multiplexers entfällt. Aufgrund dieser Zeiteinsparung sind wiederum höhere Taktraten des Speicherchips realisierbar.

Das durch die Signal-Einspeisestellen erzeugbare, in Abhängigkeit eines Umschaltsignals programmierbare Ausgangs-Taktsignal wird also in der Zeitspanne, bevor die steigende Flanke des differentiellen Eingangs-Taktsignales den entsprechenden Eingang des Zweiges der Schaltungsanordnung beaufschlagt, vorbereitet, um es dann bei Eintreffen der steigenden Flanke sofort, also ohne Verzögerung, an die Ausgänge zu legen.

Ein weiterer Vorteil der Erfindung ist, dass durch den symmetrischen Aufbau keine Laufzeitdifferenz zwischen den beiden Ausgangs-Takten, aus denen das Ausgangs-Taktsignal besteht, an den beiden Ausgängen der Schaltungsanordnung auftreten. Somit können zwei zueinander exakt komplementäre, d. h. invertierte Signale erzielt werden.

Diese und weitere Merkmale und Vorteile der Erfindung werden im folgenden unter Bezugnahme auf die nun aufgeführten Figuren näher erläutert. Es zeigen:
**Fig. 1:** Eine Ausführungsform der erfindungsgemäßen Schaltungsanordnung,
**Fig. 2**: Spannungswerte an verschiedenen Punkten der Schaltungsanordnung von Fig. 1 bei nicht-überlappendem differentiellen Eingangs-Taktsignal,
**Fig. 3**: Spannungswerte an verschiedenen Punkten der Schaltungsanordnung von Fig. 1 bei überlappendem differentiellen Eingangs-Taktsignal,
**Fig. 4:** Einen Taktverhältnis-Ausgleicher gemäß dem Stand der Technik, und
**Fig. 5**: Einen Multiplexer gemäß dem Stand der Technik.

Figur 1 zeigt eine besonders bevorzugte Ausführungsform einer erfindungsgemäßen Schaltungsanordnung 1.

Diese Schaltungsanordnung 1 besteht aus zwei zueinander symmetrischen Zweigen 2 und 3, von denen jeder (die Bezugszeichen sind hier exemplarisch für Zweig 2 angegeben) einen Eingang 8, fünf Transistoren 15, 16, 21, 22 und 23, zwei Signal-Einspeisestellen 4a und 5a, zwei aus jeweils einem Transferglied bestehende Schalter 4 und 5, zwei jeweils aus zwei Invertern bestehende Halteglieder 18 und 20, und einen Ausgang 10 aufweist. Diese Bestandteile sind in der in Fig. 1 gezeigten Weise miteinander verbunden.

Im folgenden soll die Funktionsweise dieser Schaltungsanordnung 1 näher beschrieben werden. Dazu wird ein vollständiger Taktzyklus des Zweiges 2 bei einem überlappenden, differentiellen Eingangs-Taktsignal beschrieben, wobei dieser Taktzyklus durch vier Zeitpunkte tl bis t4 (siehe Fig. 3) charakterisiert ist. Die gleichen Überlegungen gelten auch für ein nicht-überlappendes, differetielles Eingangs-Taktsignal (siehe Fig. 2).

Zu einem Zeitpunkt tl ist ein Knoten 19 entladen. Dies bedeutet, dass der Transistor 15, der durch den Knoten 19 angesteuert wird, leitet. Dies wiederum hat zur Folge, dass ein Knoten 12 aufgeladen wird. Zum Zeitpunkt tl ist ein Knoten 14 ebenfalls aufgeladen. Dies bewirkt, dass der Transistor 16 leitend ist, was wiederum zur Folge hat, dass ein Knoten 13 über Masse entladen wird.

Die Kombination aus dem aufgeladenen Knoten 12 sowie dem entladenem Knoten 13 bewirkt, dass die Schalter 4 und 5 'sperren. Diese Schalter 4, 5 sind vorzugsweise durch Transferglieder, bestehend aus jeweils einem p-Kanal-Feldeffekttransistor und einem n-Kanal-Feldeffekttransistor, realisiert. Die gesperrten Schalter 4, 5 bedingen, dass Signale CLAO (vgl. Fig. 2,3, jeweils Zeile 1) bzw. bCLAO, welche durch die Einspeisestellen 4a bzw. 5a zur Verfügung gestellt werden, über ein programmierbares Umschaltsignal CLAT erzeugt werden und an den Schaltern 4, 5 anliegen, nicht an die Ausgänge 10 und 11 der Schaltungsanordnung gelangen können. Das Signal bCLAO ist das zu CLAO inverse Signal. Das Signal an einem Knoten 17 wird demnach ausschließlich durch das Halteglied 18 gehalten.

Zu einem Zeitpunkt t2 ist der Knoten 19 aufgeladen, was zur Folge hat, dass der Transistor 15 sperrt. Des Weiteren ist zum Zeitpunkt t2 der Knoten 14 entladen, was zur Folge hat, dass der Transistor 16 ebenfalls sperrt. Dies bedeutet, dass die beiden Knoten 12 und 13 von der Stromversorgung über den Transistor 15 bzw. den Transistor 23 "entkoppelt" werden. Die an den Knoten 12 und 13 vorherrschenden Spannungswerte werden nach dem Zeitpunkt der Entkoppelung ausschließlich durch das Halteglied 20 gehalten.

Zu einem Zeitpunkt t3 trifft nun eine steigende Flanke am Eingang 8 ein. Das differentielle Eingangs-Taktsignal PhighDLCLK (vgl. Fig. 2,3, jeweils Zeile 2) wechselt also seinen Wert von niedriger Spannung auf hohe Spannung. Dies hat zur Folge, dass der Transistor 21 leitend wird. Da der Transistor 22 aufgrund des aufgeladenen Knotens 19 ebenfalls leitend ist, wird der Knoten 12 in eine Masse entladen. Da der Knoten 14 entladen ist, ist der Transistor 23 ebenfalls leitend und bewirkt über den Eingang 8 eine Aufladung des Knotens 13. Die Kombination aus entladenen Knoten 12 sowie aufgeladenem Knoten 13 bewirkt, dass die beiden Schalter 4 bzw. 5 leitend werden und die vorbereiteten Signale CLAO bzw. bCLAO auf die Ausgänge 10 und 11 gelegt werden, wo sie 'als Ausgangs-Taktsignal DLLCLK bzw. bDLLCLK abgenommen werden können (vgl. Fig. 2,3, jeweils letzte Zeile; die Signalverläufe an den Knoten 19, 14, 13 und 12 sind in den Fig. 2, 3 jeweils in den Zeilen 3 bis 6 gezeigt).

Zu einem Zeitpunkt t4 geht das durch den Schalter 4 auf den Ausgang 10 gegebene Signal CLAO über eine Verzögerungskette 24 auf einen Knoten 25. Dieser wird dadurch aufgeladen, was zur Folge hat, dass der Transistor 23 sperrt sowie der Transistor 16 leitet. Dies bewirkt, dass der Knoten 13 über die Masse entladen wird. Andererseits bewirkt die Aufladung des Knotens 25, dass der Knoten 19 entladen ist. Daraus wiederum folgt, dass der Transistor 22 sperrt sowie der Transistor 15 leitet. Dies wiederum hat zur Folge, dass der Knoten 12 aufgeladen wird. Die Kombination aus aufgeladenem Knoten 12 und entladenem Knoten 13 bewirkt, dass die beiden Schalter 4 und 5 sperren.

Somit ist ein voller Taktzyklus durchlaufen und der Zustand, wie durch den Zeitpunkt tl definiert, wieder erreicht.

Die Kopplung des Zweiges 2 über den Knoten 25 mit dem Zweig 3 bewirkt, dass dann, wenn der Knoten 25 aufgeladen wird, die beiden Knoten 26 bzw. 27 von der Stromversorgung abgekoppelt werden. Damit ist genau in dem Zeitpunkt, wenn die Schalter 4 und 5 des Zweiges 2 wieder sperren, der in Fig. 1 untere Zweig 3 bereit, bei Eintreffen einer steigenden Flanke an einem Eingang 9 die beiden Schalter 6 und 7 leitend zu machen und damit das Signal bCLAO bzw. CLAO auf die beiden Ausgänge 10 und 11 zu legen. Somit kann in der Vorbereitungsphase des Zweiges 2 die Ausgabe des gewünschten Ausgangs-Taktsignales durch den Zweig 3 übernommen werden. Dies ergibt das gewünschte, hinsichtlich der Signallaufzeit bzw. Signalgenerierungszeit optimierte Ausgangs-Taktsignal DLLCLK bzw. bDLLCLK.

Wie aus Fig. 2 sowie Fig. 3 ersichtlich, ist die oben beschriebene Erzeugung des Ausgangs-Taktsignales DLLCLK bzw. bDLLCLK bei sowohl überlappendem als auch bei nicht-überlappendem differentiellen Eingangstaktsignal möglich. Dies resultiert daraus, dass zur Erzeugung des Ausgangs-Taktsignales nur die steigenden Flanken des differentiellen Eingangstaktsignals PhighDLCLK bzw. PlowDLCLK verwendet werden.

## Patentansprüche

1. Schaltungsanordnung (1) zur Generierung eines lokalen Ausgangs-Taktsignales für die Steuerung des Zeitpunktes der Ausgabe von Daten aus einer Ausgabeverzögerungsvorrichtung am Ausgang eines Zellenfeldes eines Speichers auf eine Datenbahn, bei der
- das lokale Ausgangs-Taktsignal unter Verwendung eines Taktverhältnis-Ausgleichers und eines Multiplexers in Abhängigkeit eines differentiellen Eingangs-Taktsignales und eines programmierbaren Umstellsignales derart generierbar ist,
- dass die Ausgabe der Daten auf die Datenbahn synchronisiert ist mit entweder ganzen Taktzyklen der Datenbahn oder auch ganzzahligen Bruchteilen hiervon, **dadurch gekennzeichnet,** dass
- der Taktverhältnis-Ausgleicher aus zwei gekoppelten, gegeneinander symmetrischen Zweigen (2, 3) aufgebaut ist, in welche
- der Multiplexer mit jeweils wenigstens zwei programmierbaren Signal-Einspeisestellen (4a, 5a, 6a, 7a) integriert ist, die das Ausgangs-Taktsignal in Abhängigkeit des Umschaltsignales erzeugen und die über Schalter (4, 5, 6, 7) mit den Ausgängen (10, 11) der Schaltungsanordnung verbunden sind,
- wobei die Schalter (4, 5, 6, 7) in Abhängigkeit des differentiellen Eingangs-Taktsignales geöffnet oder geschlossen werden.

2. Schaltungsanordnung nach Anspruch 1, **dadurch gekennzeichnet,** dass jeder der symmetrischen Zweige (2, 3) des Taktverhältnis-Ausgleichers aus wenigstens einem Eingang (8, 9), wenigstens zwei Signal-Einspeisestellen (4a, 5a, 6a, 7a), wenigstens zwei daran gekoppelten Schaltern (4, 5, 6, 7), wenigstens zwei Haltegliedern (18, 20) und wenigstens einem Ausgang (10, 11) besteht.

3. Schaltungsanordnung nach einem der vorigen Ansprüche, **dadurch gekennzeichnet,** dass die Schalter (4, 5, 6, 7) jeweils vier Anschlüsse aufweisen, wovon einer mit einem der Ausgänge (10, 11), einer mit einem der Signal-Einspeisestellen (4a, 5a, 6a, 7a), und zwei mit je einem den Schalter steuernden Knoten (12, 13, 26, 27) verbunden sind.

4. Schaltungsanordnung nach einem der vorigen Ansprüche, **dadurch gekennzeichnet,** dass die Schalter (4, 5, 6, 7) aus jeweils einem p-Kanal-Feldeffekttransistor und einem n-Kanal-Feldeffekttransistor bestehen.

5. Schaltungsanordnung nach Anspruch 3 oder 4, **dadurch gekennzeichnet,** dass jeweils zwei Schalter (4, 5, 6, 7) aus jeweils unterschiedlichen Zweigen (2, 3) mit dem gleichen Ausgang (10, 11) verbunden sind.

6. Schaltungsanordnung nach einem der vorigen Ansprüche, **dadurch gekennzeichnet,** dass der Speicher aus einem SDRAM-Chip (Schreib-Lese-Speicher mit synchronem Zugriff) besteht.

7. Schaltungsanordnung nach Anspruch 6, **dadurch gekennzeichnet,** dass der SDRAM-Chip ein DDR-SDRAM-Chip (Doppeldatenraten-Schreib-Lese-Speicher mit synchronem Zugriff) ist.

8. Schaltungsanordnung nach einem der vorigen Ansprüche, **dadurch gekennzeichnet,** dass das lokale Ausgangs-Taktsignal derart generierbar ist, dass die Ausgabe der Daten auf die Datenbahn synchronisiert ist mit entweder ganzen oder auch halben Taktzyklen der Datenbahn.
